(19) Europäisches Patentamt
European Patent Office
Office européen des brevets

(11) **EP 2 286 000 B1**

(12) **EUROPEAN PATENT SPECIFICATION**

(45) Date of publication and mention
of the grant of the patent:
**29.06.2016 Bulletin 2016/26**

(51) Int Cl.:
*C23C 14/04* (2006.01)     *B81C 1/00* (2006.01)
*B82B 3/00* (2006.01)     *B82Y 30/00* (2011.01)
*B82Y 40/00* (2011.01)

(21) Application number: **09746254.3**

(22) Date of filing: **14.05.2009**

(86) International application number:
**PCT/IB2009/051995**

(87) International publication number:
**WO 2009/138960 (19.11.2009 Gazette 2009/47)**

(54) **METHOD AND SYSTEM FOR MANUFACTURING NANOSTRUCTURES**

SYSTEM UND VERFAHREN ZUR HERSTELLUNG VON NANOSTRUKTUREN

PROCÉDÉ ET SYSTÈME DE FABRICATION DE NANOSTRUCTURES

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **14.05.2008 IT TO20080358**

(43) Date of publication of application:
**23.02.2011 Bulletin 2011/08**

(73) Proprietor: **Consiglio Nazionale Delle Ricerche 00185 Roma (IT)**

(72) Inventors:
• **TORMEN, Massimo**
**I-34129 Trieste (IT)**
• **GOTTER, Roberto**
**I-34011 Duino Aurisina (Trieste) (IT)**
• **PRASCIOLU, Mauro**
**I-27036 Mortara (Pavia) (IT)**

(74) Representative: **Deambrogi, Edgardo et al Jacobacci & Partners S.p.A. Corso Emilia 8 10152 Torino (IT)**

(56) References cited:
**US-A- 4 278 710**

• **SCHALLENBERG T ET AL: "Shadow mask technology" THIN SOLID FILMS, ELSEVIER-SEQUOIA S.A. LAUSANNE, CH, vol. 412, no. 1-2, 3 June 2002 (2002-06-03), pages 24-29, XP004369882 ISSN: 0040-6090**
• **SERAPHIM ET AL: "TECHNIQUE FOR EVAPORATION OF HIGH RESOLUTION CIRCUITS OR LINES." IBM TECHNICAL DISCLOSURE BULLETIN, vol. 4, no. 10, 1 March 1962 (1962-03-01), page 14, XP001308365 US**

EP 2 286 000 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present disclosure regards the manufacturing of nanostructures and nanodevices, particularly a method and a system for manufacturing two-dimensional or three-dimensional nanostructures and nanodevices.

Devices showing new or improved features, achieved by the exploitation of physical and chemical phenomena taking place at the nanometric scale, are spreading in industrial applications.

The field of the integrated microelectronics is one of the technological sectors showing a strong development of technologies for device miniaturization at nanometric scale. Other fields of both industrial and academic interest concern technologies for data storage, photonics, plasmonics, molecular electronics, applications for biochemical sensing and medical diagnostics, to mention a few examples that exploit the development of methods for effective and accurate nanomanufacturing.

Electron beam lithography (EBL) is universally considered as the most versatile technique for nanopatterning, even if it is not compatible with a high-volume production and though other techniques are more competitive on single aspects.

For instance, the lithographic scanning probe methods, which allow the oxidation of thin surface layers of semiconductor materials according to nanometric patterns or the atom by atom or molecule by molecule assembling of desirable structures on surfaces, have higher performance in terms of resolution than electron lithography methods, but are dramatically so slow that do not allow their use in the industrial field.

Focused ion beam (FIB) method is better for the definition of a three-dimensional free pattern, but it is orders of magnitude slower than electronic methods, as well.

The method known as nanoimprinting lithography is more efficient in terms of output and costs, but generally implies electron lithography methods, since it is only able to replicate patterns obtained by other methods and not to produce such patterns.

Electron lithography is the main, direct source of patterns for high resolution methods for patterns replication, such as the projection photolithography used in the integrated electronics industry, the X-ray lithography and the above-mentioned nanoimprinting method.

Structural features smaller than 10 nanometres can be reproducibly obtained by electron beam lithography on thin films of resist with a placement accuracy, according to the prior art, of approximately 10-20 nm over whole areas of several square centimetres.

Nevertheless, disadvantageously, close nanostructures are difficult to realize due to crosstalk effects, also known as proximity effects, which arise when is desirable to realise structural elements arranged at a mutual distance less than 30-40 nanometres. The electrons of the incident beam (primary electrons) scatter on the resist producing a cascade of secondary electrons. The exposition area of the resist is thus enlarged in that the secondary electrons redistribute both energy and its associated chemical and physical effects in a volume larger than that directly intercepted by the incident beam. For instance, two near points define between them a region of high exposition for the resist due to the proximity effect, whereby, if their mutual distance is too small, during the development is obtained a single hole, comprising both points directly exposed to the beam without resolution between them.

This key issue in nanoscale manufacturing is still waiting for improved technical solutions.

Another fundamental problem is represented by the registration (alignment) of different structures forming a single multi-material nanodevice. The desirable registration accuracy is generally the order of a fraction of the size of the element governing the performance of the entire device, i.e. the order of a few nanometres. Enabling the manufacturing of nanodevices with such an accurate registration of the different structures, reliably and reproducibly over large areas, is of utmost importance for the further development of various applications and technologies, and represents a common problem for all the current nanopatterning methods of industrial interest.

In addition to electron beam lithography, focused ion beam and nanoimprinting methods, it is known a method for evaporating and for directly depositing atoms or molecules onto a substrate according to one or more angles of incidence through patterned apertures in a masking membrane, suspended at a controlled micrometric or sub-micrometric distance from substrate, having a desired pattern, for instance to obtain nanostructures and nanocontacts with a controlled gap. The masking membrane is generally made by a system having two layers of resist, wherein the first layer following the deposition order acts as a spacer layer between the substrate and the second layer of resist on which is defined a patterned aperture by lithography. The materials deposition may be obtained by multiple sources of evaporation or sublimation, placed in a ultrahigh vacuum chamber at different positions, or by moving or tilting the substrate in subsequent depositions using the same source. Thus, it is possible to produce a plurality of projections having same geometry, determined by the pattern on the masking membrane, shifted one with respect to the other according to the relative position and tilting between the source and the substrate. The sources are ideally point-like and the nanoscale pattern definition for the material deposition is only fixed by the geometry of the aperture defined on the masking membrane, maintained at a micrometric or sub-micrometer distance from the substrate. The non-infinitesimal finite extension of the source introduces a "penumbra" effect originating a loss of definition and clarity at the edges of the nanoscale deposited pattern compared to the configuration pattern of the membrane.

Nanostencil methods are also known, whose base concept is the projection of a pattern at the micrometric or nanometric scale through a single mask, placed at the proximity (at controlled distances of 10-100 micrometers), but physically separated from the substrate on which the patterned deposition of a material is going to be performed, and having the desired pattern on the substrate. In said method, the perforated membrane (typically of silicon nitride and supported on a silicon frame), is placed near the substrate, and possibly aligned to a previously defined structure. The physical separation of the mask from the target substrate for the lithography has the advantage of allowing the recycling of the mask, subject to the removal of any material deposited on it. On the contrary, the physical separation decreases the alignment accuracy of the membrane, both in terms of distance from and of parallelism over the substrate, and in terms of lateral positioning accuracy of the membrane perforated structures compared with the pre-existing structures. Therefore, using the nanostencil method it is difficult to achieve placement accuracy better than a few hundred of nanometers.

US4278710 A discloses deposition of sub-micrometer structures from a shaped source via a pinhole.

It is the object of the present invention to provide a method for lithographic manufacturing of nanostructures and nanodevices, that allows to realise packed, very fine and high resolution two-dimensional and three-dimensional structures, with placement accuracy of the order of nanometres, avoiding the drawbacks of the prior art.

According to the present invention said object is achieved by a manufacturing method of nanostructures and nanodevices whose characteristics are disclosed in claim 1.

Particular embodiments are defined in the dependent claims, which form an integral and integrating part of the present description.

A further subject of the present invention is a system for the manufacturing of nanostructures and nanodevices whose characteristics are disclosed in claim 7.

In summary, the present invention is based on the principle of the traditional photography, also known as a darkroom or pinhole camera, wherein the formation of an image is achieved by projecting the object image through a pinhole, whereby - using the proper geometrical optics terminology - each image point on a synthesis screen is formed with the contribution of the only rays emitted by the corresponding object point, that pass, without deflection, through the pinhole.

Instead of using a light source, the method according to the invention is based on using a source of atoms or molecules with a predefined pattern, adapted to emit a material to be deposited over a target substrate for the manufacturing of the nanostructure. Between the source and the target substrate a diaphragm is interposed having at least one pinhole, and more generally at least one pupil with a patterned hole of nanometric size, corresponding to the photographic iris diaphragm, adapted to be crossed by the atomic or molecular flow coming from the source (in a object-space) for the formation of a reversed image on the substrate (in a image-space). In the set-up of said system, the trajectories of atoms or molecules are straight and, advantageously, the validity of the principles of geometrical optics is rigorously verified, as the diffraction effects are totally negligible.

Specifically, the macroscopic atomic/molecular source placed in the object-space, whose image - in form of material deposition - must be formed at the nanoscale on the substrate, can be made by a crucible of a thermal source, a Knudsen cell or other types of emitting sources of atoms/molecules placed inside an ultra-high vacuum evaporation chamber, in front of which a mask is placed, for example a bored plate, having one or more configuration apertures bearing as a whole a predetermined shaping pattern of the source.

The iris diaphragm may be formed by a high resolution aperture, with a nanometre or tens of nanometers size, obtained - for instance - by lithography in a thin membrane of resist suspended at a determined fixed distance over the surface of the nanostructure formation substrate. The suspended membrane can be obtained, for example, by deposition of the resist over a polymeric sacrificial layer grown on the substrate and adapted to be subsequently dissolved, using the same apertures of the patterned membrane for the access of the solvent.

In the following of the present description said suspended membrane will be generally referred to as diaphragm, comprising one or more pupils or apertures of nanometre size (corresponding to a pinhole), preferably of circular shape. Different forms of the pinhole allows the generalization of the manufacturing capabilities to a broader class of nanostructures, including for instance the three-dimensional ones, as will be evident in the following description.

The base polymer layer acts as spacer of controlled thickness between the position of the pupil and the substrate.

The demagnification factors, correlated to the size of the structures, that can be achieved are very high. For instance, assuming that an atomic/molecular source, patterned according to a defined planar pattern, and a substrate for growing the nanostructure are separated by a distance of 50cm, and the diaphragm, with the pinhole for concentrating emitted atoms/molecules, is suspended at a distance of $0,5\mu$m from the surface of the substrate for growing the nanostructure. The result is an "atomic" (or "molecular") image whose dimensions are demagnified by a factor equal to

$$50 \cdot 10^{-2}/0.5 \cdot 10^{-6} = 10^{+6}$$

Advantageously, a consequence of the demagnification principle caused by an orthoscopic projection through a pinhole apertures is the possibility to "compose" over the target substrate two "snapshots" of different objects emitting atoms/molecules, resulting in a superposition of the two image nanostructures with a registration accuracy at the nanoscale instead of a registration accuracy of the structures of the source objects at the millimetre scale, using a demagnification factor of the order of $10^{+6}$.

A further advantage is the possibility of a parallel application of this method for contemporaneous manufacturing of a plurality of nanostructures, allowed by the formation of a plurality of corresponding apertures, possibly shaped, in the suspended diaphragm through a standard lithographic method (such as electronic or nanoimprinting lithography), obtaining a plurality of corresponding, identical nanodevices at the end of the deposition process.

Further characteristics and advantages of the invention will be fully illustrated in the detailed description which follows, provided purely by way of a non-limiting example, with reference to the appended drawings, in which:

Figure 1 is a schematic representation of the system according to the invention, in a cross sectional view;
Figure 2 is a schematic representation of the system according to the invention, according to a perspective view;
Figures 3A and 3B show a schematic representation of a variant embodiment of the system according to the invention, and a related image of a test sample; and
Figure 4 is a schematic representation of a further variant embodiment of the invention.

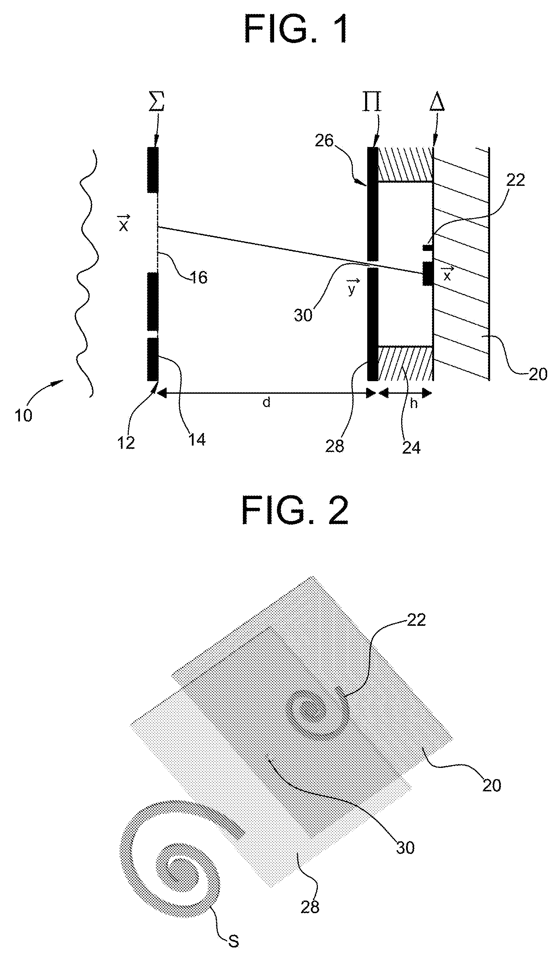

Figure 1 schematically shows, according to a cross sectional view, an arrangement of a system for manufacturing nanostructures according to the principle of the invention.

A source of atoms or molecules of any nature, shape and orientation is indicated 10. A mask for patterning the source is referred to as 12 and comprises an opaque wall 14 adapted to intercept the atoms/molecules coming from the source 12 and an aperture or a plurality of patterned apertures 16 adapted to allow the transmission of the atoms/molecules emitted by the source in the back half-space with respect to the direction of origin. The lying plane of the mask 12 is generally indicated $\Sigma$.

The arrangement adapted to produce an atomic/molecular beam according to a selected pattern that it is desirable to reproduce at the nanoscale, can therefore be indicated with the general term "emitting object", in analogy with the optical meaning, independently of the realization method by which said pattern is obtained.

Reference numeral 20 indicates a substrate having a supporting function, for realizing one or more nanostructures 22 on a surface defined by a plane $\Lambda$. At a distance determined by a spacer layer 24, a diaphragm 26 comprising a membrane 28, having at least one aperture or pinhole-type opening 30, is associated with said substrate. On the whole, the lying plane of the diaphragm 26, substantiallly parallel to the lying plane of the mask for patterning the source 12 and to the formation plane of the nanostructure, is marked as $\Pi$.

A three-dimensional, schematic representation of the system subject of the invention is provided in Figure 2, wherein elements and parts identical or functionally equivalent to those illustrated in Figure 1 are referred to with the same numerals.

Figure 2 shows a structured source S of atoms or molecules having a spiral pattern. This source can be formed through a direct patterning on an apparatus emitting atoms or molecules or it may be a "virtual" source, obtained from a free emission apparatus and setting its emission of atoms or molecules in the half-space comprising the target substrate of the nanostructure according to a defined pattern of the mask 12.

For instance, the source S can be made with a plate of tungsten or molybdenum or other metallic refractory material which, inside a groove produced at the surface or directly on the surface, contains a patterned deposit of material capable of being emitted in atomic/molecular form by evaporation or sublimation whenever the plate is heated by Joule effect.

A further variant of said patterned source can be made also with a non-conductive ceramic plate, indirectly heated by Joule effect, having a patterned deposit of material capable of being evaporated or sublimated from a groove made at its surface.

Referring again to Figure 1 showing a schematic representation of the system, a general mathematical description of the manufacturing principle according to the invention, is provided in the following.

The common wording of geometrical optics will be adopted, since its relations are applicable in this context with accuracy. In fact, the diffraction of atoms, possible and highlighted for example in recent studies about holography using Neon atoms, would require average kinetic energy of atoms extremely low, corresponding to "large" de Broglie wavelengths (order of nanometers or greater). These conditions can be achieved only by special technologies, such as "laser cooling", that allows to lower the average kinetic energy of a gas, that is its temperature, to values many orders of magnitude below those of the gas produced by common thermal sources. Other effects, potentially distorting the image according to the geometrical optics, such as the presence of magnetic and electrostatic fields or electromagnetic interference, can be easily eliminated adopting appropriate shielding systems for the deposition chamber.

Atoms emitted from the points of the patterned source, on the plane $\Sigma$, with coordinates $\vec{X}$, impinge on the substrate plane $\Lambda$ at a point of coordinates $\vec{x}$, passing through a point of coordinates $\vec{y}$ in the diaphragm plane $\Pi$ containing the aperture 30.

The geometric condition according to that $\vec{X}$, $\vec{y}$ and $\vec{x}$ are collinear, can be mathematically expressed as

$$\frac{\vec{X} - \vec{y}}{d} = \frac{\vec{y} - \vec{x}}{h} \qquad (1)$$

wherein d is the distance between the patterning mask of the source 12 and the diaphragm 26, and $h$ is the distance between the diaphragm 26 and the substrate for the nanostructure formation (plane $\Lambda$).

The demagnification factor M is defined as

$$M = \frac{d}{h}$$

and the relationship 1 can be rewritten as

$$\vec{x} = \vec{y} \cdot (1 + \frac{1}{M}) - \frac{\vec{X}}{M} \qquad (2)$$

The flux of impinging material on the substrate, denoted $\Phi(\vec{x})$, is given by integration over the plans $\Sigma$ and $\Pi$ according to the following relation

$$\Phi(\vec{x}) \propto \int S(\vec{X}) \cdot p(\vec{y}) \cdot \delta(\vec{x} + \vec{X}/M - \vec{y}(1 + 1/M)) \ d\vec{X}d\vec{y} \qquad (3)$$

wherein $S(\vec{X})$ is the local intensity of the molecular source and $p(\vec{y})$ is the "transparency" of the diaphragm, that in case of a membrane with pinhole can assume only 0 or 1 binary values.

The Dirac's function $\delta(\vec{x} + \vec{X}/M - \vec{y}(1 + 1/M))$ restricts the integration domain for $\vec{X}$ and $\vec{y}$ to a subdomain for *which X* e $\vec{y}$ are collinear with the point $\vec{x}$.

Adopting the approximation

$$\frac{M}{M+1} \approx 1$$

unnecessary from the point of view of the conclusions, but useful to simplify the notations and justified in experimental conditions wherein M is the order of $10^4$-$10^6$, the expression of the flux is given by the integral

$$\Phi(\vec{x}) \propto \int S(\vec{y}M)p(\vec{x} + \vec{y})d\vec{y} \qquad (4)$$

Clearly, when the argument of the function $p(\vec{x} + \vec{y})$ spans a length I, the argument of the function $S(\vec{y}M)$ spans a length M·I, therefore the pattern of the source $S(\vec{y}M)$ appears demagnified by a factor M on the substrate 20.

Referring to the latter expression two limiting cases are given, based on the fact that the pattern of formation of the nanostructure represented by the flux $\Phi(\vec{x})$ is basically determined by the pattern of the diaphragm's aperture $p(\vec{y})$ or by the pattern of the source $S(\vec{X})$. It is easy to notice that if the characteristic size R of the source $S(\vec{X})$, demagnified by a factor M, is smaller than the characteristic size r of the opening $p(\vec{y})$, i.e. the relation R/M<<r is verified, the source

$S(\overline{X})$ can be approximated by a point-like source, i.e. $S(\vec{X})=\delta(\vec{X})$. According to this approximation, the impinging flux on the substrate 20 is

$$\Phi(\vec{x}) \propto p(\vec{x}) \qquad (5)$$

that represents the well-known process of lift-off, commonly used to shape a deposit of metal or other material on a substrate, that fundamentally replicates the same aperture pattern obtained in a resist sacrificial layer.

In the opposite borderline case, wherein the diaphragm aperture is of size r<<R/M, the approximation $p(\vec{x})=\delta(\vec{x})$ is verified, so that the material flux impinging on the substrate 20 is given by the following relation

$$\Phi(\vec{x}) \propto S(-M\vec{x}) \qquad (6)$$

This situation corresponds to the equivalent case of pinhole camera, wherein the image of the patterned source is reversed and demagnified by a factor M on the target substrate.

Naturally, in case of a circular aperture (pinhole) of finite radius r the flux is given by the relation

$$\Phi(\vec{x}) \propto \int S(\vec{y}M) \cdot \chi(1 - \frac{\|\vec{x} + \vec{y}\|}{r})d\vec{y}$$

$$\chi(z) = \begin{cases} 1 & z \geq 0 \\ 0 & z < 0 \end{cases} \qquad (7)$$

and in this case the flux pattern correspond to a reversed, scaled and blurred image of the source.

The foregoing shows also the possibility of manufacturing three-dimensional nanostructures in case of a diaphragm with a patterned aperture.

For example, with a source of uniform intensity and with an aperture of the patterning mask of the source of length L, along the axis $X_1$, and of variable width $W(X_1)$, measured along the direction $X_2$, that is

$$S(X_1, X_2) = S_0 \chi\left(1 - \frac{\|X_1\|}{2L}\right)\chi\left(1 - \frac{\|X_2\|}{2W(X_1)}\right) \qquad (8)$$

and using a linear aperture in the diaphragm 26 parallel oriented to the direction $X_2$, i.e. wherein $p(x_1, x_2) = \delta(x_1)$, the resulting flux will be given by

$$\Phi(x_1, x_2) \propto S_0 \ \chi\left(1 - \frac{M\|x_1\|}{2L}\right)W(Mx_2) \qquad (9)$$

In more intuitive terms, in the above example, the presence of a linear aperture in the sacrificial membrane forms a material deposition as a continuous overlapping of images shifted one compared with the other according to the direction of the linear aperture present on the membrane defining the diaphragm. Therefore, it is evident that the thickness of the deposited material at a selected point of the target surface is proportional to the "number of shifted images" of the source comprising said point, that is proportional to the width of the source image along the direction of the linear aperture on the resist.

In case of a plurality of apertures in the sacrificial membrane represented by parallel, equally-spaced lines, this method allows the manufacturing of gratings with 1-dimensional periodicity at the nanoscale (within a single period) and with a free-form vertical profile.

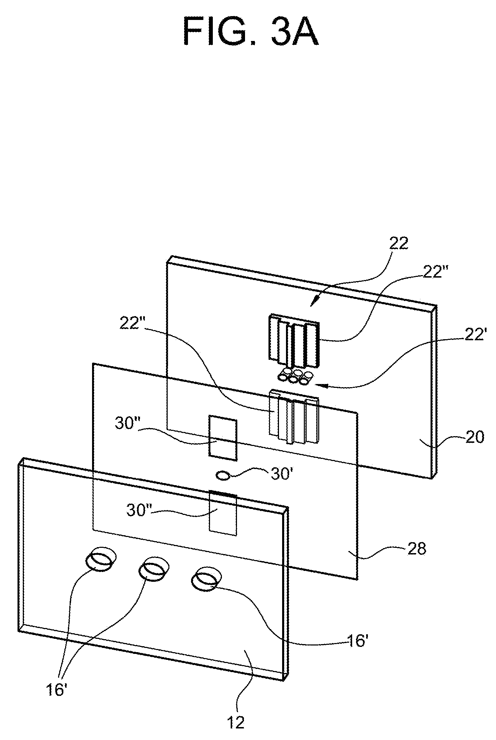

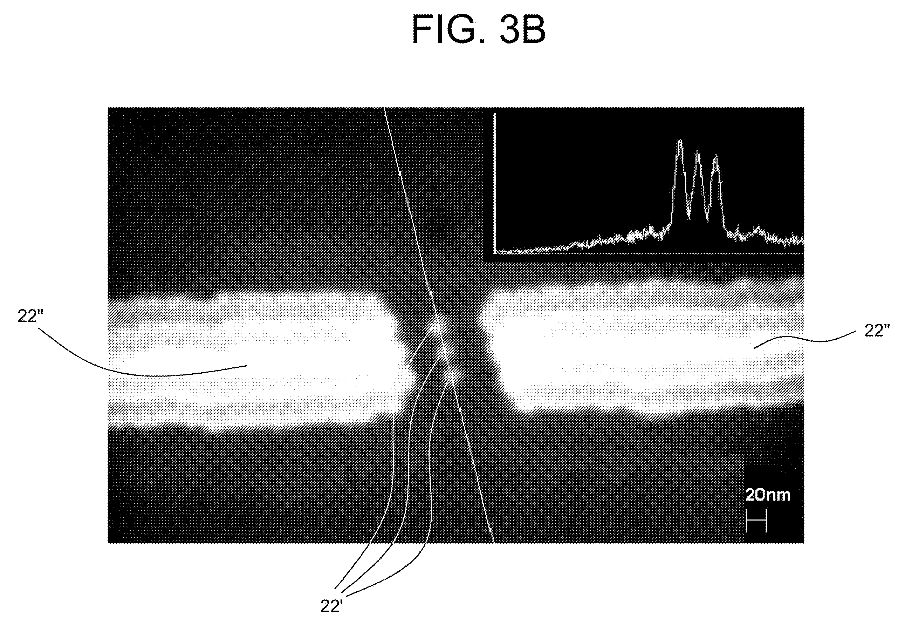

In Figures 3A and 3B are shown respectively an arrangement of the system according to the invention, and the result of manufacturing a three-dimensional nanostructure, wherein the nanostructure pattern is a convolution function of the patterned atomic/molecular source at the millimetre scale and of the diaphragm patterned aperture at the nanometre scale.

A thermal evaporator, capable of reaching base pressures of about $10^{-6}$ mbar, was used to evaporate nickel atoms from a tungsten thermal source with a ceramic crucible. A 1 micron thick, bottom layer of resist LOR B and a 0,1 micron thick, upper layer of PMMA, the latter patterned by electron beam with high resolution features (points, lines, etc..) lithography, were deposited on a silicon substrate 20. The latent lithographic pattern in PMMA was developed in a 1:3 solution of methyl isobutyl ketone and isopropyl alcohol to obtain a patterned diaphragm membrane 28, that is suspended on the substrate after the developing, in a developer bath MF319, of the LOR B layer through the apertures 30 in the PMMA membrane.

The substrate and the related diaphragm were placed inside the thermal evaporator at 35cm distance from the tungsten source. A mask for patterning the source, obtained by perforating a copper plate according to a predefined pattern, having a millimetre scale resolution, was interposed between the source and the substrate at about 1cm distance from the source. Adopting this arrangement the demagnification factor was $3 \times 10^5$. Therefore, a 1mm distance in the plane of the source patterning mask corresponds to a 3,3 nm image distance on the silicon substrate.

Figure 3B shows a SEM picture of a high resolution patterned nanostructure obtained by deposition of nickel atoms according to the arrangement shown in Figure 3A, determined by the mask 12 with three apertures 16' of 1mm in diameter, separated by a 8mm distance and by the resist membrane 28 (diaphragm 26) suspended at 1 $\mu$m distance from the surface of the silicon substrate and having a high resolution patterned aperture or pupil comprising a 12nm size central dot 30', between two interrupted lines 30". Schematically in figure 3A and experimentally in figure 3B the metallic deposit of the nanostructure 22 shows three resolved islands 22' at 27nm centre-to-centre distance as expected from the demagnification ratio and the geometry of the macroscopic pattern in the source patterning mask. In correspondence of the apertures areas 30" it is possible to see respective three-dimensional, multilevel nanostructures 22" obtained by the superposition of three shifted images. In the inset of figure 3B the intensity measured along the indicated line, connecting the points 22', shows three well resolved peaks, distinguishable over a background signal. The presence of the background signal (also visible directly in the picture) can be interpreted as a sign of atoms diffusion at the surface and/or of atoms impinging on the sample after having been deflected by scattering, showing the need for a further reduction of the sample temperature and for a further improvement of the vacuum level achieved for nanostructure manufacturing.

Conveniently, it is possible to arrange a system capable of achieving about $10^{-9}$ millibar base pressure using several pumping stages and independent thermal evaporation sources with a cryogenic panel shield. Knudsen cell can be advantageously used for the deposition of organic materials, while a material deposition by laser ablation can be also provided. In this way the system could ensure a sequential deposition for a broad class of materials according to a predefined pattern, with a nanoscale registration accuracy between subsequent deposition levels, as well as the formation of arbitrary patterns owing to the relative, synchronized movement between substrates and sources during the deposition run.

Furthermore it is also possible to reduce potentially dangerous effects for the nanostructures definition, due to the surface diffusion of atoms or molecules impinging on the substrate, by cooling down the samples at cryogenic temperatures during the deposition run.

Electron beam lithography is preferably used for manufacturing patterned, suspended membranes of resist, nanoimprinting for the definition of the high resolution apertures in the suspended membranes, while for the definition of the areas forming the underlying cavity in the spacer layer may be convenient to adopt optical or X-ray lithography, though not strictly necessary.

The clogging effect of the pinholes has been studied during the analysis of the physical limit of the process. Firstly, it represents a limitation for the maximum thickness that can be deposited through the high resolution pinholes, and at the same time represent an advantageous opportunity, if suitably controlled, since the progressive restriction of the pinhole opening allows to achieve better resolutions than the initial ones, depending on the resolution of the original lithographic structure.

Applications of the method for forming nanostructures according to the invention include, for instance, the manufacturing of memory devices, of few electrons electronic devices, of gratings with sub-100 nanometers pitch and with arbitrary three-dimensional profile, of resonant plasmonic structures for surface enhanced Raman scattering spechoscopy techniques, the manufacturing of master for nanoimprinting lithographic techniques, the manufacturing of high-resolution templates of catalysts for nanowire growth and nanoparticles self-assembling, of chemical and biochemical nanosensors.

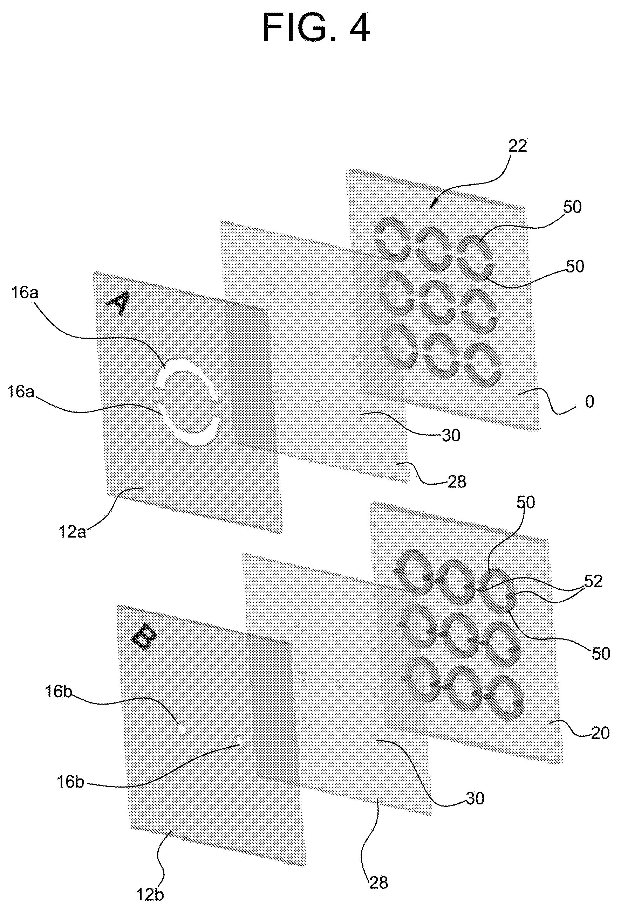

In fig. 4 is shown a further example of parallel formation of nanostructures with a nanometre scale registration on multimaterial nanodevices.

The example shows the possibility of obtaining a plurality of devices from a single source emitting atoms, by the interposition of a diaphragm comprising a plurality of pinholes. Furthermore, the example shows the possibility of nanostructures overlapping through the exposure of the same substrate to a sequence of different, patterned atomic/molecular sources, aligned at a millimetre scale, so as to obtain a nanometre scale alignment of the image on the substrate.

In detail, a first plurality of parallel formations 50 with a double semicircular-arch shape is formed from a first atomic/molecular source (not shown), patterned by the interposition of a mask 12a having a double semicircular arch pattern 16a. In a second manufacturing step the formations 50 are enhanced with functional elements 52, obtained by the projection of an atomic/molecular beam coming from a different source, patterned by the interposition of a mask 12b having a pattern made by a pair of adjacent circular apertures 16b, arranged with registered alignement with respect to the mask 12a so as to let the apertures 16b in correspondence of the gaps between the semicircular arches 16a.

A further variant embodiment of the method according to the invention is represented by the possibility to realise a sort of temporal patterning of the source, determined by the temporal evolution of the spatial position of a point-like source, instead of a spatial pattern achievable through a patterning mask for an extended, atomic or molecular source. According to this variant embodiment, the point-like source arrangement, with respect to the substrate, is sequentially varied through a relative movement, purely translatory, between the source and the substrate (wherein the source is moved with respect to the substrate or vice versa), so as to draw a predetermined pattern. This movement can be advantageously controlled via computer on the base of a CAD drawing, wherein the time law for covering the pattern is controlled by the feedback of a measure by means of a microbalance or a similar device for detecting growing of the nanostructure to be formed, so that said movement is expressed as a local control (point by point) of the nanostructure thickness along the formation path on the substrate.

Advantageously, the method and the system according to the invention are applicable to both (i) the growth of nanostructures and nanodevices by material deposition, and (ii) the formation of nanostructures and nanodevices by material deposition and the following chemical reaction of said material with the substrate or with a previously deposited material, that gives rise to compounds of the chemical species already present on the substrate and of the deposited ones, and also (iii) the formation of nanostructures and nanodevices by material deposition and the following chemical reaction of said material with the substrate or with a material previously deposited, that gives rise to volatile compounds, thus producing a removal or etching effect at the surface of the substrate.

Naturally, the principle of the invention remaining the same, the embodiments and details of construction may be widely varied with respect to those described above and illustrated purely by way of a non-limiting example, without thereby departing from the scope of protection of the present invention, defined in the appended claims.

**Claims**

1. A method for manufacturing three-dimensional, nanostructures, **characterised in that** it comprises:

   - arranging (i) a target substrate, adapted to support the formation of the nanostructure by material deposition, and (ii) at least one projection diaphragm coupled to the substrate at a first distance from it determined by a spacer layer, said diaphragm having at least one patterned aperture of nanometre size;
   - at a second distance from the target substrate, emitting an atomic/molecular beam intended to form the nanostructure, having a predetermined object pattern; and
   - orthoscopically projecting said patterned beam through the aperture of the diaphragm for forming on the substrate by demagnification a nanostructure pattern with an arbitrary three-dimensional profile which is a convolution function of the patterned beam with the diaphragm aperture,

   wherein said first distance has micrometric or sub-micrometric dimensions and said second distance has millimetre or super-millimetre dimensions.

2. A method according to claim 1, comprising the spatial patterning of the atomic/molecular beam by arranging a diffused emitting source and an associated patterning mask placed between said source and the diaphragm.

3. A method according to claim 1, comprising the spatial patterning of the atomic/molecular beam by arranging an extended emitting source having a predetermined emission pattern.

4. A method according to claim 1, comprising the temporal patterning of the atomic/molecular beam by: (i) arranging a point-like emitting source, and (ii) varying during time the mutual position between the emitting source and the target substrate.

5. A method according to claim 4, comprising the detection of the local growth of the nanostructure on the target substrate and the feedback control of the time law for covering said predetermined pattern.

6. A method according to any of the previous claims, wherein the arrangement of the projecting diaphragm includes:

- the deposition of a sacrificial spacer layer on said target substrate;
- the deposition of a resist layer on said spacer layer;
- the definition of the aperture of the diaphragm by lithography; and
- the formation and subsequent removal of an extended portion of said sacrificial spacer layer in a region around the aperture, by the action of a solvent substance of said layer capable of penetrating through the aperture, so that said resist layer is transformed in a membrane, suspended from the substrate at a distance predetermined by the thickness of said sacrificial layer.

7. A system for manufacturing three-dimensional nanostructures, **characterized in that** it comprises:

- a target substrate, adapted to support the formation of the nanostructure by deposition of material;
- at least one projection diaphragm coupled to the substrate at a first distance from it determined by a spacer layer, said diaphragm having at least one patterned aperture of nanometre size; and
- an emitting source of an atomic/molecular beam for forming the nanostructure, said source having a predetermined object pattern placed at a second distance from the target substrate, the emitting source being arranged for emitting a quantity of material in an object space so that it impinges on the diaphragm;

wherein said first distance has micrometric or sub-micrometric dimensions and said second distance has millimetre or super-millimetre dimensions, and
wherein the diaphragm is arranged for causing an orthoscopic projection of the atomic/molecular beam through said at least one patterned aperture of nanometre size on the target substrate so as to form by demagnification a nanostructure pattern which is a convolution of the patterned source with the diaphragm aperture.

8. A system according to claim 7, wherein the patterned emitting source comprises a diffused emitting source and an associated patterning mask placed between the diffused source and the diaphragm, said mask having one or more patterning apertures forming on the whole a predetermined emitting pattern.

9. A system according to claim 7, wherein the patterned emitting source comprises an emitting source extended according to a predetermined emitting pattern.

10. A system according to claim 7, wherein the patterned emitting source comprises a point-like emitting source, the position of said point-like emitting source varying with time with respect to the target substrate.

11. A system according to any of the claims 7 to 10, wherein the projecting diaphragm comprises a pinhole having a circular shape.

12. A system according to any of the claims 7 to 10, wherein the projecting diaphragm comprises a shaped aperture adapted to project a deposit of material onto the target substrate, said deposit being defined as the superposition of a discrete or continuous number of images of the emitting source, mutually shifted according to the extension of the shape of the aperture.

13. A system according to any of the claims 7 to 10, wherein the projecting diaphragm comprises a plurality of apertures adapted to define a corresponding plurality of side-by-side nanostructures.

14. A system according to any of the claims 7 to 13, wherein the projecting diaphragm comprises a resist membrane, suspended with respect to the target substrate at a distance predetermined by the thickness of a spacer formations, wherein the aperture of the diaphragm is obtainable by lithography and said spacer formations are obtainable by depositing a sacrificial layer on the substrate, and the development and the subsequent removal of an extended portion of said sacrificial layer, in a region around the aperture through the action of a solvent substance of said layer, capable of penetrating through the aperture.

**Patentansprüche**

1. Verfahren zur Herstellung von dreidimensionalen Nanostrukturen, **dadurch gekennzeichnet, dass** es umfasst:

   - Anordnen (i) eines Zielsubstrats, das zum Unterstützen der Bildung der Nanostruktur durch eine Materialabscheidung angepasst ist, und (ii) mindestens eines vorragenden Diaphragmas, das mit dem Substrat bei einem ersten Abstand davon, der durch eine Abstandshalterschicht festgelegt ist, gekoppelt ist, wobei das Diaphragma mindestens eine Öffnung mit einem Muster mit Nanometergröße aufweist,
   - Emittieren eines Atom/Molekularstrahls, der die Nanostruktur bilden soll und der ein vorgegebenes Gegenstandsmuster aufweist, bei einem zweiten Abstand von dem Zielsubstrat, und
   - orthoskopisch Projizieren des Strahls, der das Muster aufweist, durch die Öffnung des Diaphragmas zur Bildung eines Nanostrukturmusters mit einem beliebigen dreidimensionalen Profil, bei dem es sich um eine Überlagerungsfunktion des Strahls, der das Muster aufweist, mit der Diaphragmaöffnung handelt, auf dem Substrat durch Verkleinerung,

   wobei der erste Abstand Mikrometer- oder Submikrometerabmessungen aufweist und der zweite Abstand Millimeter- oder mehr als Millimeterabmessungen aufweist.

2. Verfahren nach Anspruch 1, das die räumliche Musterbildung des Atom/Molekularstrahls durch Anordnen einer diffusen Emissionsquelle und einer dazugehörigen Musterbildungsmaske, die zwischen der Quelle und dem Diaphragma angeordnet ist, umfasst.

3. Verfahren nach Anspruch 1, das die räumliche Musterbildung des Atom/Molekularstrahls durch Anordnen einer erweiterten Emissionsquelle, die ein vorgegebenes Emissionsmuster aufweist, umfasst.

4. Verfahren nach Anspruch 1, das die vorübergehende Musterbildung des Atom/Molekularstrahls durch (i) Anordnen einer punktartigen Emissionsquelle und (ii) Variieren der gegenseitigen Position zwischen der Emissionsquelle und dem Zielsubstrat im Zeitverlauf umfasst.

5. Verfahren nach Anspruch 4, welches das Erfassen des lokalen Wachsens der Nanostruktur auf dem Zielsubstrat und das Regeln des zeitlichen Ablaufs des Erstellens des vorgegebenen Musters umfasst.

6. Verfahren nach einem der vorhergehenden Ansprüche, wobei das Anordnen des vorragenden Diaphragmas umfasst:

   - das Abscheiden einer Opferabstandshalterschicht auf dem Zielsubstrat,
   - das Abscheiden einer Photolackschicht auf der Abstandshalterschicht,
   - das Festlegen der Öffnung des Diaphragmas durch Lithographie und
   - das Bilden und das anschließende Entfernen eines erweiterten Abschnitts der Opferabstandshalterschicht in einem Bereich um die Öffnung durch die Wirkung einer Lösungsmittelsubstanz der Schicht, welche die Öffnung durchdringen kann, so dass die Photolackschicht in eine Membran umgewandelt wird, die von dem Substrat bei einem Abstand gestützt wird, der durch die Dicke der Opferschicht festgelegt ist.

7. System zur Herstellung von dreidimensionalen Nanostrukturen, **dadurch gekennzeichnet, dass** es umfasst:

   - ein Zielsubstrat, das zum Unterstützen der Bildung der Nanostruktur durch eine Materialabscheidung angepasst ist,
   - mindestens ein vorragendes Diaphragma, das mit dem Substrat bei einem ersten Abstand davon, der durch eine Abstandshalterschicht festgelegt ist, gekoppelt ist, wobei das Diaphragma mindestens eine Öffnung mit Nanometergröße aufweist, die ein Muster aufweist, und
   - eine Emissionsquelle eines Atom/Molekularstrahls zur Bildung der Nanostruktur, wobei die Quelle ein vorgegebenes Gegenstandsmuster aufweist, das bei einem zweiten Abstand von dem Zielsubstrat angeordnet ist, wobei die Emissionsquelle zum Emittieren einer Materialmenge in einen Gegenstandsraum angeordnet ist, so dass sie auf das Diaphragma auftrifft,

   wobei der erste Abstand Mikrometer- oder Submikrometerabmessungen aufweist und der zweite Abstand Millimeter- oder mehr als Millimeterabmessungen aufweist.
   wobei das Diaphragma zum Bewirken einer orthoskopischen Projektion des Atom/Molekularstrahls durch die mindestens eine Öffnung mit Nanometergröße, die ein Muster aufweist, auf das Zielsubstrat angeordnet ist, so dass durch Verkleinerung ein Nanostrukturmuster gebildet wird, das eine Überlagerung der Quelle, die ein Muster aufweist, mit der Diaphragmaöffnung ist.

8. System nach Anspruch 7, bei dem die Emissionsquelle, die ein Muster aufweist, eine diffuse Emissionsquelle und eine dazugehörige Musterbildungsmaske umfasst, die zwischen der diffusen Quelle und dem Diaphragma angeordnet ist, wobei die Maske eine oder mehrere Musterbildungsöffnung(en) aufweist, die auf dem Ganzen ein vorgegebenes Emissionsmuster bildet oder bilden.

9. System nach Anspruch 7, bei dem die Emissionsquelle, die ein Muster aufweist, eine Emissionsquelle umfasst, die gemäß einem vorgegebenen Emissionsmuster erweitert ist.

10. System nach Anspruch 7, bei dem die Emissionsquelle, die ein Muster aufweist, eine punktartige Emissionsquelle umfasst, wobei die Position der punktartigen Emissionsquelle in Bezug auf das Zielsubstrat im Zeitverlauf variiert.

11. System nach einem der Ansprüche 7 bis 10, bei dem das vorragende Diaphragma ein kleines Loch mit einer Kreisform umfasst.

12. System nach einem der Ansprüche 7 bis 10, bei dem das vorragende Diaphragma eine geformte Öffnung umfasst, die zum Vorragen lassen einer Materialabscheidung auf dem Zielsubstrat angepasst ist, wobei die Abscheidung als Überlagerung einer diskreten oder kontinuierlichen Anzahl von Bildern der Emissionsquelle festgelegt ist, die gemäß der Erstreckung der Form der Öffnung zueinander verschoben sind.

13. System nach einem der Ansprüche 7 bis 10, bei dem das vorragende Diaphragma eine Mehrzahl von Öffnungen umfasst, die zum Festlegen einer entsprechenden Mehrzahl von nebeneinander liegenden Nanostrukturen angepasst sind.

14. System nach einem der Ansprüche 7 bis 13, bei dem das vorragende Diaphragma eine Photolackmembran umfasst, die in Bezug auf das Zielsubstrat bei einem Abstand gestützt ist, der durch die Dicke von Abstandshalteranordnungen vorgegeben ist, wobei die Öffnung des Diaphragmas durch Lithographie erhältlich ist und die Abstandshalteranordnungen durch Abscheiden einer Opferschicht auf dem Substrat erhältlich sind, und wobei die Entwicklung und die anschließende Entfernung eines erweiterten Abschnitts der Opferschicht in einem Bereich um die Öffnung durch die Wirkung einer Lösungsmittelsubstanz der Schicht erfolgt, welche die Öffnung durchdringen kann.

**Revendications**

1. Procédé de fabrication de nanostructures à trois dimensions, **caractérisé en ce qu'**il comprend :

   - la disposition (i) d'un substrat de destination adapté pour supporter la formation de la nanostructure par dépôt de matière et (ii) d'au moins un diaphragme de projection couplé au substrat à une première distance de celui-ci déterminée par une couche d'écartement, ledit diaphragme ayant au moins une ouverture structurée de dimensions nanométriques ;
   - l'émission, à une deuxième distance du substrat de destination, d'un jet d'atomes ou de molécules destiné à produire la nanostructure, ayant un motif d'objet prédéterminé, et
   - la projection orthoscopique dudit jet structuré à travers l'ouverture du diaphragme pour former sur le substrat, par démagnification, un motif de nanostructure ayant un profil à trois dimensions arbitraire qui résulte de la convolution du jet structuré avec l'ouverture du diaphragme,

   dans lequel ladite première distance a des dimensions micrométriques ou inférieures et ladite deuxième distance a des dimensions millimétriques ou supérieures.

2. Procédé selon la revendication 1, comprenant la structuration spatiale du jet d'atomes ou de molécules par la disposition d'une source d'émission diffusée et le placement d'un masque de structuration associé entre ladite source et le diaphragme.

3. Procédé selon la revendication 1, comprenant la structuration spatiale du jet d'atomes ou de molécules par la disposition d'une source d'émission étendue ayant un motif d'émission prédéterminé.

4. Procédé selon la revendication 1, comprenant la structuration temporelle du jet d'atomes ou de molécules par : (i) la disposition d'une source d'émission ponctuelle et (ii) la variation de la durée de la position mutuelle entre la source d'émission et le substrat de destination.

5. Procédé selon la revendication 4, comprenant la détection de la croissance locale de la nanostructure sur le substrat de destination et le contrôle de rétroaction de la loi de temps pour la couverture dudit motif prédéterminé.

6. Procédé selon l'une quelconque des revendications précédentes, dans lequel la disposition du diaphragme de projection comprend :

   - le dépôt d'une couche d'écartement sacrifiée sur ledit substrat de destination ;
   - le dépôt d'une couche de vernis épargne sur ladite couche d'écartement ;
   - la définition de l'ouverture du diaphragme par lithographie ; et
   - la formation puis l'élimination d'une partie étendue de ladite couche d'écartement sacrifiée dans une région entourant l'ouverture, sous l'action d'une substance de ladite couche agissant comme un solvant qui peut pénétrer à travers l'ouverture de sorte que ladite couche de vernis épargne est transformée en une membrane suspendue à partir du substrat à une distance prédéterminée par l'épaisseur de ladite couche sacrifiée.

7. Système de fabrication de nanostructures à trois dimensions, **caractérisé en ce qu'**il comprend :

   - un substrat de destination pouvant soutenir la formation de la nanostructure par dépôt de matière ;
   - au moins un diaphragme de projection couplé au substrat à une première distance de celui-ci déterminée par une couche d'écartement, ledit diaphragme ayant au moins une ouverture structurée de dimensions nanométriques ;
   - une source d'émission d'un jet d'atomes ou de molécules pour former la nanostructure, laquelle source possède un motif d'objet prédéterminé placé à une deuxième distance du substrat de destination, la source d'émission étant disposée pour émettre une quantité de matière dans un espace d'objet de telle façon qu'elle atteigne le diaphragme ;

   dans lequel ladite première distance a des dimensions micrométriques ou inférieures et ladite deuxième distance a des dimensions millimétriques ou supérieures et
   dans lequel le diaphragme est disposé de façon à créer une projection orthoscopique du jet d'atomes ou de molécules à travers ladite au moins une ouverture structurée de taille nanométrique sur le substrat de destination afin de former, par démagnification, un motif de nanostructure qui est une convolution de la source structurée avec l'ouverture du diaphragme.

8. Système selon la revendication 7, dans lequel la source d'émission structurée comprend une source d'émission diffuse et un masque de structuration placé entre la source diffusée et le diaphragme, lequel masque possède une ou plusieurs ouvertures de structuration formant ensemble un motif d'émission prédéterminé.

9. Système selon la revendication 7, dans lequel la source d'émission structurée comprend une source d'émission étendue selon un motif d'émission prédéterminé.

10. Système selon la revendication 7, dans lequel la source d'émission structurée comprend une source d'émission ponctuelle dont la position varie avec le temps par rapport au substrat de destination.

11. Système selon l'une quelconque des revendications 7 à 10, dans lequel le diaphragme de projection comprend un trou sténopéique de forme circulaire.

12. Système selon l'une quelconque des revendications 7 à 10, dans lequel le diaphragme de projection comprend une ouverture conformée permettant de projeter un dépôt de matière sur le substrat de destination, lequel dépôt est défini comme la superposition d'un nombre discret ou continu d'images de la source d'émission, décalées les unes par rapport aux autres suivant l'extension de la forme de l'ouverture.

13. Système selon l'une quelconque des revendications 7 à 10, dans lequel le diaphragme de projection comprend plusieurs ouvertures permettant de définir un nombre correspondant de nanostructures juxtaposées.

14. Système selon l'une quelconque des revendications 7 à 13, dans lequel le diaphragme de projection comprend une membrane en vernis épargne, suspendue par rapport au substrat de destination à une distance prédéterminée par l'épaisseur de formations d'écartement, l'ouverture du diaphragme pouvant être obtenue par lithographie et les formations d'écartement pouvant être obtenues par le dépôt d'une couche sacrifiée sur le substrat et le développement puis l'élimination d'une partie étendue de ladite couche sacrifiée dans une région entourant l'ouverture sous l'action d'une substance de ladite couche ayant une action de solvant et capable de pénétrer à travers l'ouverture.

# FIG. 1

# FIG. 2

# FIG. 3A

# FIG. 3B

22"

22"

22'

20nm

# FIG. 4

**EP 2 286 000 B1**

**Patent documents cited in the description**

- US 4278710 A